(19) Europäisches Patentamt
European Patent Office
Office européen des brevets

(11) Publication number: **0 023 722**
**B1**

(12) **EUROPEAN PATENT SPECIFICATION**

(45) Date of publication of patent specification: **21.11.85**

(51) Int. Cl.$^4$: **G 03 F 7/08**

(21) Application number: **80104601.2**

(22) Date of filing: **05.08.80**

(54) **Lithographic printing plate and process.**

(30) Priority: **06.08.79 US 64322**

(43) Date of publication of application:
**11.02.81 Bulletin 81/06**

(45) Publication of the grant of the patent:
**21.11.85 Bulletin 85/47**

(84) Designated Contracting States:
**BE DE FR GB NL**

(56) References cited:
**DE-A-2 514 864**
**FR-A-2 133 728**
**FR-A-2 340 566**
**FR-A-2 354 576**
**FR-A-2 366 598**
**US-A-3 891 439**

(73) Proprietor: **Fromson, Howard A.**
**15 Rogues Ridge Road**
**Weston Connecticut 06880 (US)**

(72) Inventor: **Gracia, Robert F.**
**451 First Parish Road**
**Scituate Massachusetts 02066 (US)**
Inventor: **Fromson, Howard A.**
**15 Rogues Ridge Road**
**Weston Connecticut 06880 (US)**

(74) Representative: **Schulze Horn, Stefan, Dipl.-Ing. et al**
**Goldstrasse 36**
**D-4400 Münster (DE)**

**EP 0 023 722 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

The invention relates to a process for making an aluminium lithographic printing plate from a silicated aluminium substrate having a hydrophilic, anionic, negatively-charged surface,

- coating said substrate with a layer of water soluble diazo material being capable of chemical alteration by actinic light,
- exposing an image area of the diazo to actinic light to alter the diazo material thereat for adhering said portions of the diazo material to the substrate in the image area,
- removing unexposed diazo material from the non-image areas by contacting the full diazo layer after exposure with a solution consisting essentially of an anionic material,
- and rinsing with water to provide a printing plate having an image with an oleophilic diazo layer and a clean, hydrophilic background.

Lithographic printing techniques, using for example anodized and silicated aluminium base plates such as described in US—A—3 181 461 issued May 4, 1965, have come into widespread use in the printing industry and especially in offset printing and direct lithographic printing by newspapers using converted letterpress printing presses.

The FR—A—2 133 728 describes a process for making a lithographic printing plate whereby a lithographic substrate having a silicated surface is coated with a single layer of an oleophilic composition comprising a stable, water insoluble light-sensitive diazo resin and a polyamide resin. On exposure to light the diazo resin becomes insolubilized and firmly adhered to the substrate.

The unreacted diazo resin in the remaining unexposed areas of the plate is afterwards removed by an aqueous solution of a developing medium, preferably a salt of lauryl alcohol sulfate.

The anionic material of this developing solution doesn't react with the diazo resin in the light exposed areas, because the diazo material is completely exposed by light and all of the reactive sits of each diazo molecule are crosslinked by the light. According to the state of the art long exposure times are necessary to obtain a strong image on the plates.

An object of the present invention is to provide a process for making an improved and highly sensitive lithographic printing plate, which reduces the amount of exposure time to obtain a strong image on the plate.

Accordingly, the present invention provides a process for making an aluminium lithographic printing plate characterized in that the coating consists of a pure diazo material, having at least two diazonium groups per molecule coated onto the substrate, that the exposure to actinic light is only incomplete, that during the step of treating the exposed printing plate the image of the incompletely exposed areas of the diazo layer is simultaneously reinforced by using an anionic material selected from the group of alkali metal salts of alkylaryl sulfonates, alkali metal salts of alkyl sulfonates and alkali metals and ammonium salts of sulfated higher fatty alcohols, whereby a coupling reaction between the unaltered portion of incompletely exposed diazo material and anionic surfactant takes place, said reaction completing the incomplete reaction initiated by said exposing to actinic to amplify the oleophilic properties of the diazo layer in the exposed areas.

Lithographic printing plates of the invention, more specifically lithographic printing plates using light sensitive multifunctional diazonium materials, preferably diazonium resins or polymeric diazo materials formed by the condensation reaction with aldehydes, are greatly improved in their photoresponse which comes about through an amplification treatment which develops the plate at the same time.

In the past, a great deal of effort has been devoted to the amplification of photochemical reactions initiated by the absorption of actinic radiation. Higher sensitivity can be achieved by increasing quantum yields or by amplification. By quantum yields it is meant that for every photon of incident radiation of specified wavelength that is absorbed by a photochemical material, there is a photochemical reaction which is signaled by either the disappearance or creation of a product. The ratio of this primary process is the quantum yield. For substances such as diazonium salts this ratio is usually one or less than one. To increase the quantum yield such things as deactivators, florescence compounds, etc., must be avoided. More fruitful means of doing the same, however, can be achieved by amplification.

Amplification to achieve photographic speed can be done by development in classical silver halide chemistry. The amplification factor is $10^6$. In electrophotography using charge dissipation and subsequent toning, amplification of $10^6$ can be achieved. In photopolymers, the amplification via polymerization after the initial primary process has been initiated is $10^5$. With respect to diazonium materials, however, there is no known amplification technique. This means that the primary process is all that is realized with diazonium materials. There have been some instances where quantum yields in the area of two have been achieved but generally a quantum yield approaching one is all that is possible. It has been discovered that polyfunctional diazonium materials, that is materials containing two or more light sensitive diazonium groups in the same molecule, can be effectively amplified according to the invention as claimed. While not intending to be bound by any particular theory, it is believed that the invention functions in the following manner:

Diazonium salts such as 4-Diazo-di-phenylamine sulfate, reacted with formaldehyde or

paraformaldehyde forms a polymeric condensation product having a functionality greater than two. This polymeric structure is described in a paper by Ken-ichi Shimazu, *Photography Science and Engineering*, Vol. 17, No. 1, Jan./Feb. 1973. An idealized structure for this material is as follows:

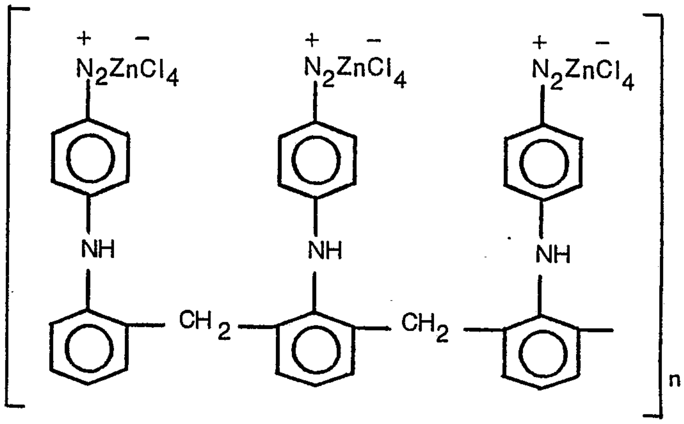

Taking into account the polyfunctionality of this material, upon exposure to actinic radiation, a few diazo groups will absorb photons. Photon absorption destroys diazo groups in a random fashion. From a statistical point of view, the chances that all the diazonium groups on a particular molecule will be destroyed upon exposure is very remote. Even with very high levels of actinic radiation, the chances that every diazonium group on a given molecule will be destroyed are minimal. Therefore, after exposure (particularly to low levels of actinic light) it is believed that the diazonium material takes on the following configuration:

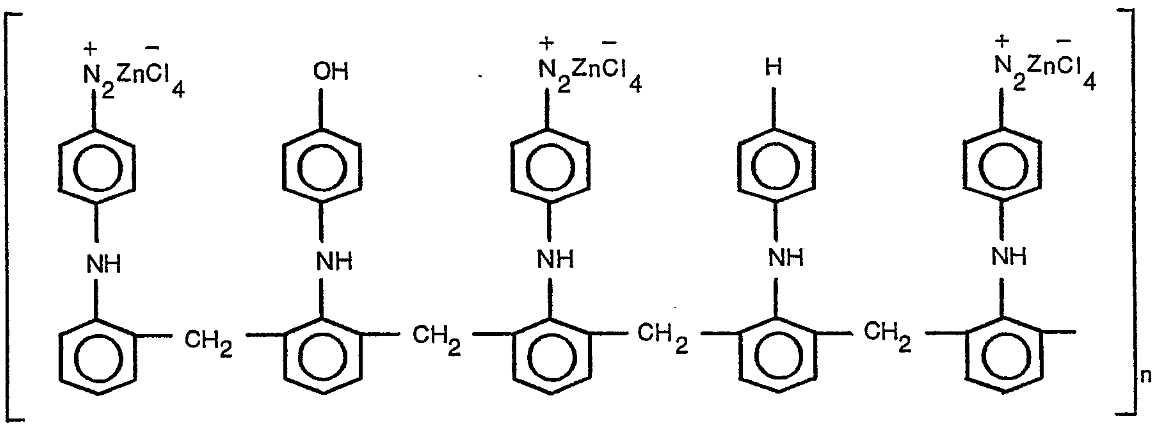

The amplification step follows exposure to actinic light. Diazonium molecules are very strong cations and react instantaneously with materials of the opposite charge, namely, anionic materials such as surfactants, dyes, polymers and the like. Thus, when an incompletely exposed polyfunctional diazonium material is treated with an anionic surfactant such as sodium lauryl sulfate, a coupling reaction between diazonium material and the anionic surfactant takes place. The coupled material produces an oleophilic amplification in the exposed (image) area while at the same time, in the unexposed background area, the coupling reaction results in simultaneous removal of the light sensitive material. It is thus believed that there is a two-step sequence, first the coupling reaction between the diazonium material and an anionic material in an ionizing reaction medium, followed by dissolution in the reaction medium of the coupled material from the background. Dissolution does not follow coupling (or amplification) in the image area because prior exposure to actinic light adheres the light sensitive material to the substrate which prevents dissolution in the reaction medium.

Suitable anionic surfactants are water soluble and include the alkali metal salts of alkylaryl sulfonates having 1 to 20 carbon atoms in the alkyl portion and 6 to 14 carbon atoms in the aryl portion, alkali metal salts of alkyls sulfonates having 12 to 20 carbon atoms and ammonium and alkali metal salts of sulfated higher fatty alcohols having 10 to 20 carbon atoms. Anionic materials used in the invention as claimed are dissolved in an ionizing reaction medium (usually water) and the concentration of the anionic material is sufficient to dissolve the coupled reaction product between the diazonium and anionic materials without exceeding the solubility product that would otherwise cause precipitation.

Specific examples of anionic surfactants are given hereintogether with a test to determine suitability. The effectiveness of certain anionic surfactants can be improved by adjusting the pH or by using a cosolvent such as an alkyl alcohol containing 1—8 carbon atoms or a glycol.

While a pH adjuster or co-solvent can be present, the presence of other materials such as cationic that will interfere with or prevent the coupling reaction between the diazonium and anionic materials in both the

image (exposed) and non-image areas and dissolution of the coupled material in the non-image areas, must be avoided.

Cationic dyes can be applied to the anionically charged substrate or incorporated in the light sensitive material to provide a visible image on the plate. Suitable dyes include basic cationic dyes such as Victoria green Rhodamine B, Rhodamine 5GLD, crystal violet, extra pure APN, Paper Blue R and the like.

Cationic light sensitive materials used in the invention as claimed are diazonium materials having at least two reactive sites per molecule with each reactive site being capable of being chemically altered by light or chemically reacted with an anionic material. For example, 4-diazo diphenylamine condensed with a carbonyl compound such as formaldehyde has the needed multiplicity of reactive sites each having the required dual functionality. Such a condensed diazo compound coupled with an aromatic compound such as the sulphonic acid of benzophenone to make it water insoluble is only light sensitive and cannot undergo chemical amplification according to the invention as claimed. Preferred are water soluble diazonium compounds but water insoluble compounds can also be used. Suitable diazonium compounds are described in US—A—3,849,392 and US—A—3,311,605.

The hydrophilic, anionic lithographic substrate can be a single sheet or a laminate and can be rigid or flexible. The substrate may be a coated paper, a plastic film or sheet or a metallic sheet each treated to render the surface hydrophilic and anionically charged. The preferred lithographic substrate is anodized aluminum which may be pretreated before anodizing to roughen or grain the surface, for example using mechanical, chemical or electrochemical techniques as are well known in the art and it may be post-treated after anodizing. It is preferred to impart hydrophilicity and anionic charge by silicating as described in US—A—3,181,461.

After treatment with the anionic material, the image can be reinforced with an oleophilic UV curable material which can be coated on and then cured. This is described in DE—A—2951795 which is incorporated herein by way of reference.

Suitable UV curable materials are commercially available from a number of sources in the form of UV curable inks, coatings, oligomers and monomers. Such commercially available materials can be obtained from the following companies: Inmont Corporation, Sinclair & Valentine, Celanese Chemical Company, 3-M Company, Desoto Chemical Company, Paulimer Industries, Shell Chemical, Mobile Chemical, W. R. Grace, Design Coat Company, and Ware Chemical Corporation.

UV curable materials including monomers and oligomers are described in the following patents:

| | |
|---|---|
| U.S. 3,297,745 | 1967 |
| U.S. 3,380,381 | 1968 |
| U.S. 3,673,140 | 1972 |
| U.S. 3,770,643 | 1972 |
| U.S. 3,712,871 | 1973 |
| U.S. 3,804,736 | 1974 |

There are also materials that will cure upon exposure to other sources of radiation, for example an electron beam. These curable materials can be used in special applications in place of the UV material and are commercially available. Electron beam curable compositions are described in US—A—3586526 to US—A—3,586,530, 1971.

Chemical amplification after exposure to actinic radiation according to the invention makes it possible to substantially reduce exposure times normally required with diazonium compounds. This can be expressed empirically as simply the amount of actinic light necessary to produce an image capable of running on a lithographic press. Chemical amplification according to claim 1 makes it possible to reduce the amount of light needed to attain this by a factor of from 2 to 10 or more. This means that a diazo sensitized plate that normally required 1 or 2 minutes to image can now be imaged in a matter of seconds. The amount of diazo on the plate can also be reduced.

The amount of light necessary to produce an image capable of running on a lithographic press can also be expressed in terms of millijoules per square centimeter. In carrying out the invention the amount of actinic light can be from less than about 100 to as little as 5 millijoules/$cm^2$ at UV wave lengths of 300—400 nanometers. This means that plates of the invention can be imaged with low power lasers such as are marketed by EOCOM Inc.

The invention as claimed thus greatly improves the photo response of lithographic printing plates to a point approaching projection speed while using conventional diazonium materials. Exposure times can be reduced to 1 to 10 seconds under conventional conditions whereas prior techniques using the same conditions required 60 or more seconds. This means that lithographic plates according to the invention as claimed can be imaged using lasers, with a projection size negative or with contact size negative. Plates can also be made with continuous tone images using a negative without the customary screen.

After treatment with the anionic material the developed amplified image can be blanket exposed to actinic light to photo react any remaining light sensitive sites in the image area. This includes coupled diazonium and anionic materials which remain light sensitive after coupling.

A test to determine whether a particular anionic material is suitable is as follows:

A 5% aqueous solution of the anionic material is prepared. An aluminum lithographic plate grained, anodized, and silicated is coated with a 1% solution of a light sensitive diazo condensation product (such as Fairmont's Chemical Diazo #4). The coated plate is exposed to a Stauffer Graphic Arts Guide for a relatively

short period of time — 5 to 10 seconds. The exposed plate is immersed in the 5% solution of anionic material for 10 seconds. The plate is then rinsed and lacquered with a standard lithographic lacquer (such as Fairmont's Black Lacquer). Another plate, identically prepared and exposed, is treated with the Black lacquer only. This is the control. The two plates are compared. If the anionic material is effective, the post-treated plate will show significant difference in light sensitivity versus the control.

The effectiveness of certain anionic materials can be enhanced by either a pH adjustment and/or the use of a co-solvent. The optimum pH for most anionic materials useful in the invention as claimed is in the range of pH 2—10. Suitable co-solvents are alcohols such as ethanol, butanol and the like and glycols.

Many different salts of anionic materials are suitable; these include sodium, lithium, ammonium, or triethanol amine salts and the like. Examples of suitable anionic surfactants (and their commercial sources) are as follows:

1. Sodium lauryl sulfate (Proctor & Gamble, Equex S. Equex SP, Alcolac, Inc. Sipex SB).
2. Ammonium lauryl sulfate (Alcolac, Inc., Sipon L-22).
3. Sodium lauryl ether sulfate (Alcolac, Inc., Sipon ES).
4. Sodium dodecyl benzene sulfonate (Alcolac, Inc. Siponate DS-XO).
5. Ammonium lauryl ether sulfonate (Alcolac, Inc. Sipon EA).
6. Triethanolamine lauryl sulfate (Alcolac, Inc. Sipon LT-6).
7. Sodium alkyl sulfate (Alcolac, Inc., Sipex OLS).
8. Sodium stearate (Emery Inds.).
9. Sodium palmitate (Emery Inds.).
10. Sodium oleate (Matlerson, Coleman & Bell).
11. Dioctyl sodium sulfosuccinate (Cyanamid, Aerosol OT).
12. Tetrasodium N—Cl, 2-dicarboxyethyl 1)-N-octadecyl sulfosuccinate (Cyanamid, Aerosol 22).
13. Sodium Xylene sulfonate (Witco Chemical, Ultra SXS).
14. Sodium toluene sulfonate (Witco Chemical, Ultra STS).
15. Sodium cumene sulfonate (Witco Chemical, Ultra SCS hydrotrope).
16. Sodium dihexyl sulfosuccinate (Cyanamide Aerosol AY-65).
17. Sodium diamyl sulfosuccinate (Cyanamide Aerosol AY-65).
18. Anionic phosphate surfactant (Rohm & Haas Co., Triton QS-30).
19. Sodium alkylaryl polyether sulfate (Rohm & Haas Co., Triton W-30 conc.).
20. Phosphate surfactant, potassium salt (Rohm & Haas Co., Triton H-66).
21. Sodium alkylaryl polyether sulfonate (Rohm & Haas Co., Triton X-200).

Sodium lauryl sulfate is preferred because of its availability and cost.

Example 1 (control)

A 1% solution of the formaldehyde condensation product of a diphenylamine-4-diazonium zinc chloride double salt (Fairmont Diazo Resin #4) is prepared in water. The solution is placed in a two roll coating machine. A brushed grained, anodized and silicated plate, 10×16×0.12 (Ano-Coil Delta Plate) is coated face down through the machine. The coated plate is dried and placed in a Nu Arc Plate Maker exposure unit, 61 centimeters from the source (4 kw lamp). A Stauffer Graphic Arts Step scale is step exposed on the plate for the following times: 1 second, 5 seconds, 10 seconds, 15 seconds, 30 seconds, and 60 seconds. The exposed plate is then developed with Fairmont's black lacquer for wipe-on plates. After development, rinsing, and drying the solid step exposure level is read for each exposure time: 1 second — no image, 5 seconds — no image, 10 seconds — a ghost image, 15 seconds — a solid 1, 30 seconds — a solid 3, and 60 seconds — a solid 5 — normal for this type of plate system.

Example 2

An aluminum lithographic plate, similar to Example 1, is coated and exposed for the same time sequences as in Example 1. The exposed plate is then totally immersed, 5 seconds, in a 5% solution of sodium lauryl sulfate, rinsed and treated with Fairmont's black wipe-on lacquer. The solid step exposure reading for each exposure time is as follows: 1 second — solid 2, 5 seconds — solid 6, 10 seconds — a solid 8, 15 seconds — a solid 10, 30 seconds — a solid 12, and 60 seconds — a solid 14. At 60 seconds, a solid 5 was achieved as in Example 1. This demonstrates that immersion in sodium lauryl sulfate produces a 9-step amplification.

Example 3

According to US—A—3,790,556, the reaction products between water-soluble, polyfunctional diazonium salts and anionic surfactants (e.g. sodium lauryl sulfate), are soluble in toluene-isopropyl alcohol (60/40).

A plate coated and exposed as in Example 1 is developed in a 5% solution of sodium lauryl sulfate. After development, the plate is rubbed thoroughly with a cotton pad saturated with a 60/40 solution of toluene-isopropyl alcohol. The plate is rinsed and lacquered with Fairmont's black lacquer. The observed photosensitivity is similar to Example 1.

Example 4

An aluminum lithographic plate is coated and exposed as in Example 1. The plate is developed in a 5% solution of sodium lauryl sulfate rinsed, dryed, and re-exposed (blanket) for 1-1/2 minutes. The re-exposed plate is then rubbed with a cotton pad saturated with toluene/alcohol rinsed and lacquered with black Fairmont lacquer. The observed photoresponse is similar to Example 2.

Example 5

An aluminum lithographic plate is coated and exposed as in Example 1. The exposed plate is then immersed in 5% sodium lauryl sulfate for 5 seconds, rinsed, and inked with black offset press ink. The observed photoresponse is: 1 second — a solid 2, 5 seconds — a solid 5, 10 seconds — a solid 7—8, 15 seconds — a solid 9, 30 seconds — a solid 11, and 60 seconds — a solid 13.

Example 6

An aluminum lithographic plate similar to Example 1 is exposed and processed as in Example 2 except that an Ultra Violet sensitive emulsion of the following composition is used in place of the Fairmont lacquer.

A 30 g Inmont UV Blue Ink
12.5 cc Span 80 (I.C.I.)
120 ml Cellosolve Acetate

B 250 ml 8°B Gum Arabic
12.5 g Pluronic F 38 (BASF)

Mix by adding B to A while stirring. The emulsion can be applied with sponge, cloth, or brush. After treatment with the UV emulsion the plate is re-exposed in a high intensity UV processor such as a PPG Industries, Model PC2502A at 7.6 m/min. The photoresponse is similar to Example 2 but the toughness and abrasion resistance of the image is much improved.

Example 7

A brush grained, anodized silicated aluminum plate (Alloy 1100) is immersed in a dye bath of a 1% solution of a basic (cationic) dye such as DuPont's Victoria Green Liquid, Rhodamine B Liquid, Rhodamine 5 GLD, crystal violet extra pure APN or Paper Blue R Liquid. The dyed plate is then coated as in Example 1. The coated plate is then exposed in a 4 kw Nu Arc flip top exposure unit for 5 seconds to a newspaper page negative. The exposed, dyed plate is immersed in a 5% solution of sodium lauryl sulfate. Immediately upon removal from the bath a strong visible image is seen on the plate.

Example 8

A brushed grained, silicated, and anodized plate (Ano-Coil's Delta Plate) is coated with a 1% diazo coating (Fairmont Resin #4) containing 1/2% Victoria Green Liquid dye (DuPont). The plate is dryed and exposed for 5 seconds on a Nu Arc as in Example 7. The plate is developed in a 5% solution of ammonium lauryl sulfate. Upon application of the developer with a sponge, a visible image becomes immediately apparent.

Example 9

A lithographic plate (Ano-Coil's Delta plate) is dyed in a 1% solution of Victoria Green Liquid. The plate is coated with a 1% solution of Fairmont diazo resin #4 exposed to a newspaper negative for 10 seconds and immersed in a 5% solution of sodium lauryl sulfate. Immediately an image becomes visible. The plate is rinsed in tap water and dryed. The plate is placed on a Goss Metro Press and 50,000 good images are obtained.

Example 10

A plate is prepared as in Example 8 but after development it is rubbed with a UV curable emulsion (Example 6) rinsed, dryed, and re-exposed through a PPG UV processor at 7.6 m/min. The plate is placed on a Goss Metro newspaper press and 250,000 impressions are obtained.

Example 11

A brush grained, anodized, silicated, aluminum plate is coated with a 1% solution of water soluble polyfunctional diazo resin (Fairmont's diazo resin #4) and dryed. The sensitized plate is then placed in an Eocom Laserite Platemaker and scanned with an ion argon laser. A scanning time of 1 minute is necessary to scan a plate approximately 23×14 $cm^2$. The approximate laser power at the plate surface is 8 $mj/cm^2$. After scanning, the plate is developed with a 5% solution of sodium lauryl sulfate. The plate was then rubbed with black press ink producing a strong quality image. A step wedge scanned onto the plate showed 7 total steps with a solid 5 steps.

Example 12

A plate was coated, laser exposed and developed as in Example 11 using 10 mj/cm$^2$ laser power. This time after development, the plate was rubbed with a UV curable emulsion described in Example 6. The thus treated plate was then exposed in a P.P.G. processor at 7.6 m/min. A tough durable image results. A scanned Stauffer Step Guide showed 9 total steps with a solid 5.

Example 13

A plate as described in Example 11 was dyed with a cationic water soluble dye, 1% Victoria Green (DuPont). The plate was coated with a 1% solution of diazo resin and dryed. This plate was laser exposed as in Example 11 with laser power of 4 mj/cm$^2$.

After exposure to the laser, the plate is developed by hand with sodium lauryl sulfate (5% solution). The thus treated plate is then lacquered with a black lacquer from Western Litho Company (Jet Black). A dense black image results.

Example 14

A brush grained, anodized, silicated plate is coated with a 3% solution of a water soluble light-sensitive polyazo resin (Fairmont's Diazo #4). The thus sensitized plate is exposed and processed as in Example 2. The results are similar showing significant speed increases over conventionally processed plates.

Example 15

This example is to verify the importance of using polyfunctional diazo compounds opposed to monoazo compounds. In this example an aluminum plate similar to Example 2 is sensitized with a monoazo molecule such as paradiazo diphenylamine sulfate. The plate is exposed on a Nu Arc for 1 second, 5 seconds, 10 seconds, 15 seconds, 30 seconds, and 60 seconds through a Stauffer Step Guide. The exposed plate is then immersed in a 5% solution of sodium lauryl sulfate for 5 seconds, rinsed and lacquered with Fairmont's black lacquer.

Result

1 second — no image, 2 seconds — no image, 5 seconds — no image, 10 seconds — no image, 15 seconds — ghost image, 30 seconds — step 1, 60 seconds — step 2. Compare with Example 2.

Example 16

A plate is prepared as above only this time it is lacquered only, no immersions in SLS. Results — if anything a slight improvement over Example 16, 30 seconds — step 1—2 and 60 seconds — solid step 4.

Example 17

This example is to show the utility of solvent soluble polymerized polyazo molecules. A 1% solution of subtractive diazo BBP (MRI Inc.), polymethylene paradiazo diphenylamine zinc fluoride phosphate is made up in (80/20) methylcellusolve/-DMF. A plate is coated and exposed similar to Example 2. The exposed plate is immersed in a 50/50 solution of 5% sodium lauryl/butyrolactone (GAF). The plate is rinsed and lacquered with a Fairmont Black lacquer.

Result

1 second — ghost image, 5 seconds — step 2, 10 seconds — step 4, 15 seconds — step 5, 30 seconds — step 7, and 60 seconds — step 9.

Example 18

A plate was processed as in previous example except that the developer was 100% butyrolactone — the plate rinsed and lacquered.

Result

1 second — no image, 5 seconds — no image, 10 seconds — no image, 15 seconds — ghost image, 30 seconds — step 1, and 60 seconds — step 2. This verifies the utility of sodium lauryl sulfate even in solvent systems.

Example 19

This experiment illustrates the utility of anionic developers containing no organic solvents to develop photosensitive polyazo compounds which are solvent soluble. This type of solvent soluble diazo material is described in detail in U.S. 3,790,556. A similar solvent soluble diazo product was prepared in the following manner:

To 1,500 milliliters of a 5% solution of sodium lauryl sulfate is added the following with stirring 300 ml of a 10% solution of diazo resin #4 (Fairmont Chemical). A voluminous precipitate is then dissolved in 2-methyoxyethanol to make up a 1% coating solution. Rhodamine is also added at the 1/2% level.

An aluminum lithographic plate grained, anodized, and silicated is coated using a two roll coater and exposed similarly to Example 2. The exposed plate is then processed in a 5% water solution of sodium

lauryl sulfate. After processing, the results are a strong visible image. The plate is then inked producing a clean lithographic product.

**Claims**

1. A process for making an aluminium lithographic printing plate from a silicated aluminium substrate having a hydrophilic, anionic, negatively-charged surface,

— coating said substrate with a layer of water soluble diazo material being capable of chemical alteration by actinic light,
— exposing an image area of the diazo to actinic light to alter the diazo material thereat for adhering said portions of the diazo material to the substrate in the image area,
— removing unexposed diazo material from the non-image areas by contacting the full diazo layer after exposure with a solution consisting essentially of an anionic material,
— and rinsing with water to provide a printing plate having an image with an oleophilic diazo layer and a clean, hydrophilic background, characterized in that the coating consists of a pure diazo material, having at least two diazonium groups per molecule coated onto the substrate, that the exposure to actinic light is only incomplete, that during the step of treating the exposed printing plate the image of the incompletely exposed areas of the diazo layer is simultaneously reinforced by using an anionic material selected from the group of alkali metal salts of alkylaryl sulfonates, alkali metal salts of alkyl sulfonates and alkali metals and ammonium salts of sulfated higher fatty alcohols, whereby a coupling reaction between the unaltered portion of the incompletely exposed diazo material and the anionic surfactant takes place, said reaction completing the incomplete reaction initiated by said exposing to actinic light to amplify the oleophilic properties of the diazo layer in the exposed area.

2. Process according to claim 1, characterized in that the exposed areas after treatment with said anionic material are further reinforced with UV-cured material.

3. Process according to claim 1, characterized in that the image is blanket exposed to actinic light after the treatment with the anionic material.

4. Process according to claim 1, characterized in that the treated substrate is coloured with a cationic dye.

5. Process according to claim 1, characterized in that cationic dyes are incorporated in the diazo material.

**Patentansprüche**

1. Verfahren zur Herstellung einer lithographischen Aluminium-Druckplatte aus einem silizierten Aluminiumsubstrat, welches ein hydrophile, anionische, negativ geladene Oberfläche aufweist, wobei

— das Substrat mit einer Schicht eines wasserlöslichen Diazomaterials, welches durch aktinisches Licht chemisch veränderbar ist, beschichtet wird,
— ein Bildbereich des Diazomaterials mit aktinischem Licht belichtet wird, um das Diazomaterial so zu verändern, daß die belichteten Abschnitte des Diazomaterials im Bildbereich an dem Substrat haften,
— unbelichtetes Diazomaterial in den nichtbelichteten Bereich durch Behandlung der gesamten Diazoschicht nach der Belichtung mit einer im wesentlichen aus einer anionischen Substanz bestehenden Lösung entfernt wird,
— und mit Wasser gespült wird, um eine ein Bild mit einer oleophilen Diazoschicht und einen reinen hydrophilen Hintergrund aufweisende Druckplatte zu erhalten, dadurch gekennzeichnet, daß die Beschichtung auf dem Substrat aus einem reinen Diazomaterial besteht, welches mindestens zwei Diazoniumgruppen pro Molekül enthält, daß die Beschichtung mit aktinischem Licht nur unvollständig erfolgt, und daß während der Behandlung der belichteten Druckplatte das Bild der unvollständig belichteten Bereiche der Diazoschicht gleichzeitig mittels einer anionischen Substanz aus der Gruppe der Alkalimetallsalze von Alkylarylsulfonaten, Alkalimetallsalze von Alkylsulfonaten sowie Alkalimetall- und Ammoniumsalze von sulfatierten höheren Fettsäurealkoholen verstärkt wird, wobei zwischen dem unveränderten Teil des unvollständig belichteten Diazomaterials und der anionischen oberflächenaktiven Substanz eine Koppulungsreaktion stattfindet, durch welche die durch die Belichtung mit aktinischem Licht eingeleitete unvollständige Umsetzung vervollständigt wird und die oleophilen Eigenschaften der Diazoschicht im belichteten Bereich verstärkt werden.

2. Verfahren nach Anspruch 1, dadurch gekennzeichnet, daß die belichteten Bereiche nach der Behandlung mit der anionischen Substanz mittels eines im UV härtbaren Materials weiter verfestigt werden.

3. Verfahren nach Anspruch 1, dadurch gekennzeichnet, daß das Bild nach der Behandlung mit der anionischen Substanz vollständig mit aktinischem Licht belichtet wird.

4. Verfahren nach Anspruch 1, dadurch gekennzeichnet, daß das behandelte Substrat mit einem kationischen Farbstoff eingefärbt wird.

5. Verfahren nach Anspruch 1, dadurch gekennzeichnet, daß kationische Farbstoffe in das Diazomaterial eingearbeitet werden.

**Revendications**

1. Procédé de fabrication d'une plaque d'impression lithographique en aluminium à partir d'un substrat en aluminium silicaté présentant une surface hydrophile anionique chargée négativement, par revêtement du substrat avec une couche de produit diazo soluble dans l'eau susceptible de modification chimique par une lumière actinique, exposition d'une région d'image de la substance diazo à la lumière actinique afin de modifier la substance diazo de manière à faire adhérer les dites parties de la substance diazo au substrat dans la région d'image, élimination de la substance diazo non exposée des régions de non image par mise en contact de toute la couche diazo, après exposition, avec une solution comprenant essentiellement une substance anionique, et rinçage à l'eau pour obtenir une plaque d'impression comportant une image avec une couche diazo oléophile et un fond hydrophile propre, caractérisé en ce que le revêtement consiste en une substance diazo pure, comportant au moins deux groupes diazonium par molécule appliquée sur le substrat, en ce que l'exposition à la lumière actinique est seulement incomplète, en ce que pendant l'opération de traitement de la plaque d'impression exposée l'image des régions incomplètement exposées de la couche diazo est simultanément renforcée par utilisation d'une substance anionique choisie dans le groupe des sels de métaux alcalins d'alkylaryl sulfonates, des sels de métaux alcalins d'alkyl sulfonates et des sels de métaux alcalins et d'ammonium d'alcools gras supérieurs sulfatés, de sorte qu'il se produit une réaction d'accouplement entre la partie non modifiée de la substance diazo incomplètement exposée et la substance anionique tensioactive, cette réaction complétant la réaction incomplète déclenchée par l'exposition à la lumière actinique de manière à amplifier les propriétés oléophiles de la couche diazo dans la région exposée.

2. Procédé suivant la revendication 1, caractérisé en ce que les régions exposées après traitement avec la substance anionique sont encore renforcées avec une substance durcie par rayonnement ultraviolet.

3. Procédé suivant la revendication 1, caractérisé en ce que l'image est exposée en blanchet à la lumière actinique après le traitement avec la substance anionique.

4. Procédé suivant la revendication 1, caractérisé en ce que le substrat traité est coloré avec une teinture cationique.

5. Procédé suivant la revendication 1, caractérisé en ce que des teintures cationiques sont incorporées dans la substance diazo.